# EUROPEAN PATENT APPLICATION

(11) **EP 4 567 164 A1**
(43) Date of publication of application: **11.06.2025**
(21) Application number: 24157552.1
(22) Date of filing: 14.02.2024
(51) Int. Cl.: C30B 23/06, C30B 29/16, C30B 29/36, C30B 29/40, C23C 14/06, C23C 14/24, C23C 14/50

(54) **A CRYSTAL GROWTH APPARATUS WITH MULTIPLE DEPOSITION SITES IN AND METHOD USING THE SAME**

(30) Priority: 08.12.2023 CN 202311688934
(71) Applicant: HKT Technology Corporation, Taipei City 11242 (TW)
(72) Inventor: Hsiung, Chih-Yung, 11242 Taipei City (TW); Hu, Kai-Ti, 11242 Taipei City (TW); Weng, Min-Hang, 813014 Kaohsiung City (TW)
(74) Representative: Studio Torta S.p.A.

(57) **Abstract**

The present invention discloses a crystal growth apparatus with multiple deposition sites in, which mainly includes: a heating cavity with a rotatable pillar inside; at least one set of heating bearing components connected to the rotatable pillar, and the heating bearing component includes a crucible, a filter, a plurality of deposition sites, the crucible has a plurality of source materials; a heat generator, arranged inside the heating cavity, for providing the heat energy to the heating cavity; and a plurality of rigid devices, as an auxiliary heater or a deposition heat sink, so that at least one thermal field inside the heating cavity is formed with a 2D or a 3D thermal gradient. The invention further discloses a crystal growth process with multiple deposition sites. By forming 2D or 3D thermal gradients at multiple deposition sites, compound crystals with fewer defects can be stably produced.

## Description

### TECHNICAL FIELD

The present invention pertains to a crystal growth apparatus and its manufacturing process. More specifically, it pertains to a crystal growth apparatus and manufacturing process for high-quality silicon carbide compound crystals. By creating 2D or 3D thermal gradients at multiple deposition sites, this method allows for the stable and rapid production of compound crystals with fewer defects.

### BACKGROUND

Crystal growth is the process in which pre-existing crystals enlarge as additional molecules or ions are incorporated into sites within the crystal lattice. A crystal is defined as an arrangement of atoms, molecules, or ions in an orderly repeating pattern, known as a lattice, extending in all three spatial dimensions. Therefore, crystal growth distinguishes itself from droplet growth because, throughout the growth process, molecules or ions must accurately occupy the proper lattice positions to facilitate the development of an ordered crystal.

Widely used compound crystals include silicon carbide (SiC), gallium nitride (GaN), aluminum nitride (AlN), and gallium oxide (Ga₂O₃). These crystals are mostly semiconductor materials with excellent thermal conductivity and chemical stability. Viewed from the perspective of transistor characteristics, such as dielectric breakdown properties and saturation drift velocity, they are highly anticipated as materials for next-generation semiconductor devices. Compound crystal growth technologies can be roughly divided into three types, namely Physical Vapor Transport (PVT), High Temperature Chemical Vapor Deposition (HTCVD), and Solution Growth.

The growth of compound crystal GaN crystals often occurs under high temperature and high pressure, where ammonia (NH3) is passed through liquid gallium (Ga) to cultivate needleshaped GaN. Additionally, GaN can be grown using Chemical Vapor Deposition (CVD). High-temperature growth results in high-quality GaN and remains the most common method for growing GaN buffer layers to date. Despite the improvement in GaN crystal quality with the use of buffer layer technology, there is still a certain gap when compared to GaN components grown directly on GaN substrates.

In addition to being more expensive than Si substrates, compound crystal SiC substrates also face the challenge of reducing defects and achieving sufficient high quality in single crystal substrates. When silicon carbide is heated at normal pressure, it sublimates at a temperature of about 2000°C, so the crystal growth method by the CZ method (Czochralski) or the FZ method (floating zone) cannot be used. Therefore, today's silicon carbide single crystals are mainly produced by the sublimation method headed by the modified Rayleigh Method. The sublimation method is currently a common method for mass production of silicon carbide single crystals. However, even if a silicon carbide single crystal obtained by the sublimation method is used to manufacture a power device, its characteristics may not be sufficient. The reason is that minimizing defects in silicon carbide single crystals is challenging. The crystal growth by the sublimation method is a precipitation phenomenon from the gas phase, the growth rate is slow, and temperature management in the reaction space is also difficult.

Therefore, the compound crystal growth method using a solution method has recently attracted attention. The solution method for compound crystals can be broadly categorized into (a) Traveling Solvent Method (TSM), (b) Slow Cooling Technique (SCT), (c) Vapor Liquid Solid (VLS), and (d) Top Seeded Solution Growth (TSSG). The conventional solution-based compound crystal growth relies on creating a temperature gradient throughout the solution to foster the growth of single crystals. Many compound crystals do not melt under normal pressure. In this method, the crystal growth of compound crystals occurs in a state very close to thermal equilibrium. Consequently, compared to compound crystals obtained through sublimation methods, this approach yields compound crystals with fewer defects. However, this conventional crystal growth method faces a challenge: the composition of raw materials changes over time, making it difficult to sustain stable, long-term single crystal growth of compound crystals.

In light of the aforementioned issues, it is imperative to propose a crystal growth apparatus and its process capable of stably and rapidly producing a variety of compound crystals with minimal defects. This can be achieved by establishing 2D or 3D thermal gradients at multiple deposition sites. The compounds include silicon carbide (SiC), gallium nitride (GaN), aluminum nitride (AlN), and gallium oxide (Ga₂O₃), among others.

### SUMMARY

In view of the above problems, it is necessary to propose a crystal growth apparatus and its process, which can stably and quickly produce diverse compound crystals with few defects by forming 2D or 3D thermal gradients at multiple deposition sites, including silicon carbide (SiC), gallium nitride (GaN), aluminum nitride (AlN), and gallium oxide (Ga₂O₃), etc.

The primary objective of the present invention is to introduce a crystal growth apparatus with multiple deposition sites. This apparatus achieves stable and rapid production of compound crystals such as silicon carbide (SiC), gallium nitride (GaN), aluminum nitride (AlN), and gallium oxide (Ga₂O₃). It accomplishes this by utilizing an auxiliary heater or a deposition heat sink in conjunction with several thermal field adjustment components, creating 2D or 3D thermal gradients at multiple deposition sites.

The secondary objective of the present invention is to introduce a crystal growth process with multiple deposition sites. Primarily, this process involves creating a single or multiple distinct thermal fields within the heating cavity. The source material undergoes evaporation within these thermal fields, and with the assistance of a filter, stable and rapid production of compound crystals such as silicon carbide (SiC), gallium nitride (GaN), aluminum nitride (AlN), and gallium oxide (Ga₂O₃) is achieved at multiple deposition sites.

In order to achieve the above main purpose, the present invention proposes a crystal growth apparatus with multiple deposition sites, including: A heating cavity with a rotatable pillar inside; At least one heating bearing component is connected to the pillar. The heating bearing component includes a crucible, a filter, and a plurality of deposition sites. The crucible has a plurality of source materials; A heat gene rator, disposed inside the heating cavity, for providing the heat energy to the heating cavity; and A plurality of rigid devices serves as an auxiliary heater or a deposition heat sink, so that at least one thermal field inside the heating cavity is formed with a 2D or a 3D thermal gradient.

According to one feature of the present invention, the heat generator is a radio frequency heating coil that forms a single or a plurality of different thermal fields in the heating cavity. The source materials of the heating-bearing component evaporate in these thermal fields, and the vapor passes through the filter to reach the deposition sites.

According to a feature of the present invention, it also includes a plurality of insulators arranged inside the heating cavity to protect a cylindrical or a rectangular water jacket on the surface of the heating cavity.

According to one feature of the present invention, it additionally comprises a plurality of thermal field adjustment components, positioned within the heating cavity and situated between the heating bearing components. This arrangement ensures that each heating bearing component within the heating cavity experiences a distinct thermal gradient in this thermal field.

According to one feature of the present invention, the material of the crucible is selected from one of the following: an alloy, a metal, a ceramic, or a compound material, or a combination thereof.

According to one feature of the present invention, a gas is introduced into the heating cavity. The gas is selected from one of Ar, N₂, CO, CO₂, and doping gases, and the pressure range of the gas is 10-6 mbar to 10 atm.

According to one feature of the present invention, the state of the source material can be in liquid phase, solid phase, gas phase, or mixed phase. The deposition sites have a powdery crystal serving as a nucleation point, and the powdery crystal is selected from one of SiC, GaN, AlN, or Ga₂O₃ powder crystals.

According to one feature of the present invention, the viewports at the top, middle and bottom of the heating cavity are equipped with infrared pyrometers to detect the temperature of the heating cavity.

According to one feature of the present invention, the filter is used to regulate the gases that are heated and sublimated by the source materials and will have different filtration speeds along with the thermal gradients of different thermal fields.

In order to achieve the above secondary purpose, the present invention proposes a crystal growth process with multiple deposition sites, which uses a crystal growth apparatus with multiple deposition sites, including the following steps:
(1) providing a plurality of source materials on a crucible of a heating bearing component in a heating cavity;
(2) Providing a heat energy to the heating cavity to form a single or multiple different thermal fields, so that the source materials of the heating bearing components evaporate in the thermal fields, and the vapor reaches the deposition sites through a filter; and
(3) Through an auxiliary heater or a deposition heat sink, the thermal field inside the heating cavity is formed with a 2D or a 3D thermal gradient.

In summary, the crystal growth apparatus and process with multiple deposition sites of the present invention have the following effects:
(1) Versatile crystal growth apparatuses are easy to manufacture and integrate.
(2) The heating cavity creates a single or multiple different thermal fields.
(3) Multiple deposition sites generate 2D or 3D thermal gradients.
(4) Stable and rapid production of compound crystals with few defects.

### BRIEF DESCRIPTION OF THE DRAWINGS

The present disclosure will become better understood from the detailed description given herein below and the accompanying drawings which are given by way of illustration only and thus are not intending to limit the present disclosure and wherein:
FIG. 1 is a main structural diagram for illustrating the crystal growth apparatus of multiple deposition sites according to the present invention.
FIG. 2 is a schematic diagram of a heating bearing component used to illustrate a crystal growth apparatus with multiple deposition sites according to the present invention.
FIG. 3 is a flow chart of the crystal growth process of multiple deposition sites of the present invention.
FIG. 4 is a schematic photographic of the source materials in the heating bearing component of the present invention.
FIG. 5 is a schematic photograph of the deposition sites in the heating bearing component of the present invention.
FIG. 6 is a schematic photograph of the compound crystal in the heating bearing component of the present invention.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

In addition, the terms used in the present disclosure, such as technical and scientific terms, have its own meanings and can be comprehended by those skilled in the art, unless the terms are additionally defined in the present disclosure. That is, the terms used in the following paragraphs should be read on the meaning commonly used in the related fields and will not be overly explained, unless the terms have a specific meaning in the present disclosure.

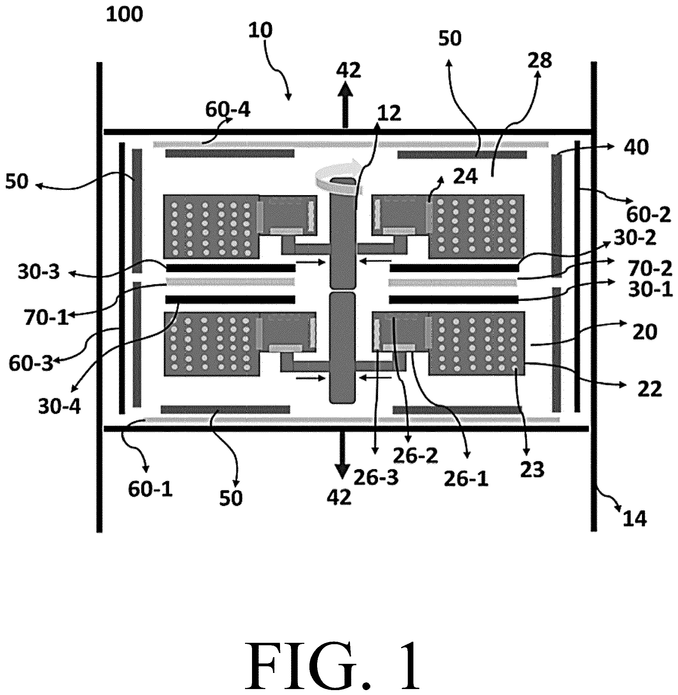

Please refer to FIG. 1, which is a schematic side view of the structure of an embodiment of a crystal growth apparatus 100 with multiple deposition sites. The crystal growth apparatus 100 with multiple deposition sites mainly includes: a heating cavity 10, at least one heating bearing component 20, a plurality of rigid devices 30-1, 30-2, 30-3, 30-4 and a heat generator 40.

The heating cavity 10 is equipped with a rotatable pillar 12 inside. The heating bearing component 20 is connected to the pillar 12 and is arranged at different positions up and down the pillar 12. Through the rotatable pillar 12, the heating bearing component 20 can rotate inside the heating cavity 10, and the rotation speed can be controlled. A cylindrical or rectangular water jacket 14 is provided on the surface of the heating cavity 10. The water jacket 14 is used to reduce the temperature of the outer surface of the heating cavity 10. For example, the heating bearing components 20 are in at least six groups, divided into three upper groups and three lower groups, and are connected to the pillar 12.

These rigid devices 30-1, 30-2, 30-3, 30-4 serve as auxiliary heaters or deposition heat sinks, allowing the formation of a 2D or 3D thermal gradient in at least one thermal field 28 inside the heating cavity 10. That is to say, the rigid devices 30-1, 30-2, 30-3, and 30-4 can be connected to external heaters to regulate the thermal field distribution of the heating cavity 10; or, the rigid devices 30-1, 30-2, 30-3, and 30-4 are materials that dissipate heat quickly, such as carboncontaining compounds, and are used to regulate the thermal field distribution of the heating cavity 10.

The heat generator 40 is disposed inside the heating cavity 10 and is used to provide a thermal energy to the heating cavity 10 to form a single or multiple different thermal fields 28 in the heating cavity 10. In one embodiment, the heat generator 40 surrounds the inside of the heating cavity 10 and is mainly an electric heating coil, an electromagnetic induction coil, a radio frequency heating coil, a microwave waveguide heat source, etc. Arrow number 42 indicates the direction of heat dissipation.

In one embodiment, the crystal growth apparatus 100 having multiple deposition sites adopts a solution method to form compound crystals. Since many compound crystals are difficult to melt under normal pressure, the heating cavity 10 requires a very high temperature. In this solution method, the crystal growth of the compound crystal is carried out in a state very close to thermal equilibrium. Therefore, compared with the compound crystal obtained by the sublimation method, a compound crystal with fewer defects can be obtained. For example, in the method of manufacturing silicon carbide compound crystals by the solution method, carbon (C) is dissolved in the silicon (Si) melt in the graphite crucible from the high-temperature part below the crucible, and the silicon carbide seed crystal is brought into contact with this The Si-C melt is allowed to undergo epitaxial growth on the silicon carbide seed crystal to obtain silicon carbide compound crystals.

The heating bearing component 20 includes a crucible 22, a filter 24, and a plurality of deposition sites 26-1, 26-2, 26-3. The crucible has a plurality of source materials 23. The material of the crucible 22 is selected from one of al-loys, metals, ceramics, and compound materials. The crucible 22 has source materials 23 containing compound crystals silicon carbide (SiC), gallium nitride (GaN), aluminum nitride (AlN), and gallium oxide (Ga₂O₃), etc. The source materials 23 will melt when heated. or sublimation. The deposition sites 26-1, 26-2, and 26-3 can be equipped with seed crystals to supply steam or sublimation gas generated by melting the source materials 23, and grow specific com-pound crystals on the seed crystals. The filter 24 is used to regulate the vapor or sublimation gas generated by the thermal melting of the source materials 23, and will have different filtration speeds along with the thermal gradients of different thermal fields.

The state of the source material 23 can be liquid phase, solid phase, gas phase and mixed phase, and the deposition sites 26-1, 26-2, 26-3 have a powdery crystal as a nucleation point, and the powdery crystal is selected from one of SiC, GaN, AlN and Ga₂O₃ powdery crystals.

In one embodiment, the source materials 23 are preferably high-purity silicon carbide powder raw materials placed in the crucible 22 and heated to above 1,800°C in a negative pressure or inert gas (low-pressure argon) environment. This process causes the silicon carbide powder raw material to decompose and sublime into Si, C, Si2C, and SiC2 gases due to heat. In another embodiment, Si melt can be formed in the crucible 22. However, since the solubility of C in the Si melt is extremely low, around 1 at%, transition metals, such as Ti, Cr, Ni, Fe, Al, Sn, Ga, or various rare earth elements, may be added to the Si melt to facilitate the dissolution of C.

In one embodiment, the heat generator 40 is heated by a radio frequency induction coil and is configured in the area of the heating cavity 10 to heat the crucible 22 of the heating bearing component 20. At the same time, by controlling the pressure of the heating cavity 10, the source materials 23 of the heating bearing component 20 are melted or sublimated in the thermal fields 28, and the steam or sublimation gas generated by the melting passes through the filter 24 and reaches the position sites 26-1, 26-2, 26-3. In one embodiment, by controlling the pressure of the heating cavity 10 to a low vacuum, the source materials 23 of the heating bearing component 20 sublimate in the thermal fields 28 to form a chemical vapor phase phenomenon, which is deposited on the above some deposition sites 26-1, 26-2, and 26-3.

The crystal growth apparatus 100 with multiple deposition sites further includes a plurality of insulators 60-1, 60-2, 60-3, 60-4, which are arranged in-side the heating cavity 10 and located in the heating cavity. Between the heating bearing components 20, the cylindrical or rectangular water jacket 14 is used to protect the water jacket 14 from overheating and melting.

It should be noted that in order to provide the heating cavity 10 to form a single or multiple different thermal fields 28, the crystal growth apparatus 100 with multiple deposition sites further includes a plurality of thermal field adjustment components 70-1 and 70-2, is arranged inside the heating cavity 10 and between the heating bearing components 20, so that each heating bearing component 20 of the heating cavity 10 is in the thermal field 28 with different thermal gradients.

The heating cavity 10 has a connected ventilation pipe, which can pass in a gas, so that the cavity is in the atmosphere of the gas. Preferably, the gas is selected from one of Ar, N2, CO, CO2 and doping gases. The gas pressure range of the heating cavity 10 is from 10⁻⁶ mbar to 10 atm.

Since each heating bearing component 20 that reaches the heating cavity 10 can be in the thermal field 28 with different thermal gradients, the viewports at the top, middle and bottom of the heating cavity 10 have an infrared pyrometer 50. The infrared pyrometer 50 is used to detect the temperature of the heating cavity 10, and by understanding the temperature distribution, a central control module (not shown) of the crystal growth apparatus 100 with multiple deposition sites controls the heat generation. The actions of the heat generator 40, the rigid devices 30-1, 30-2, 30-3, 30-4 and the thermal field adjustment components 70-1, 70-2 can accurately ensure that each heating bearing component 20 in the heating cavity 10 is positioned in the thermal field 28 with different thermal gradients. That is, in addition to the heat generator 40 providing a heat source to the heating cavity 10, the rigid devices 30-1, 30-2, 30-3, 30-4 can be selected as auxiliary heaters or deposition heat sinks, and The thermal field adjustment components 70-1 and 70-2 can be activated appropriately to adjust each heating bearing component 20 of the heating cavity 10 to be in the thermal field 28 with different thermal gradients.

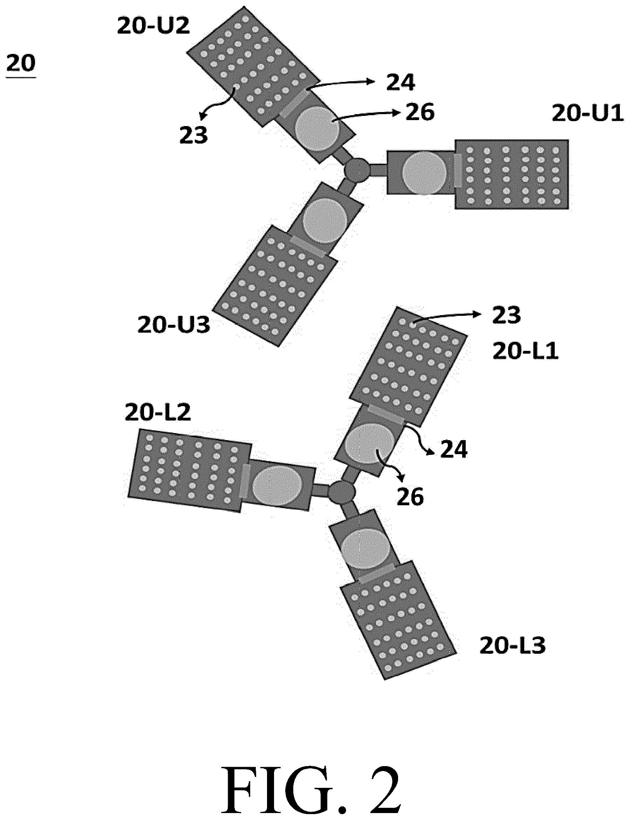

FIG. 2 is a schematic diagram of a heating bearing component used to illustrate a crystal growth apparatus with multiple deposition sites according to the present invention. In the heating cavity 10, there are three upper and lower groups of heating bearing components 20. The upper three groups of heating bearing components are 20-U1, 20-U2, and 20-U3, and the lower three groups of heating bearing components are 20-L1, 20-L2 and 20-L3. It should be noted that all heating bearing components will have respective crucibles 22, source materials 23, filters 24, and a plurality of deposition sites 26 (26-1, 26-2 and 26-3 are represented by 26).

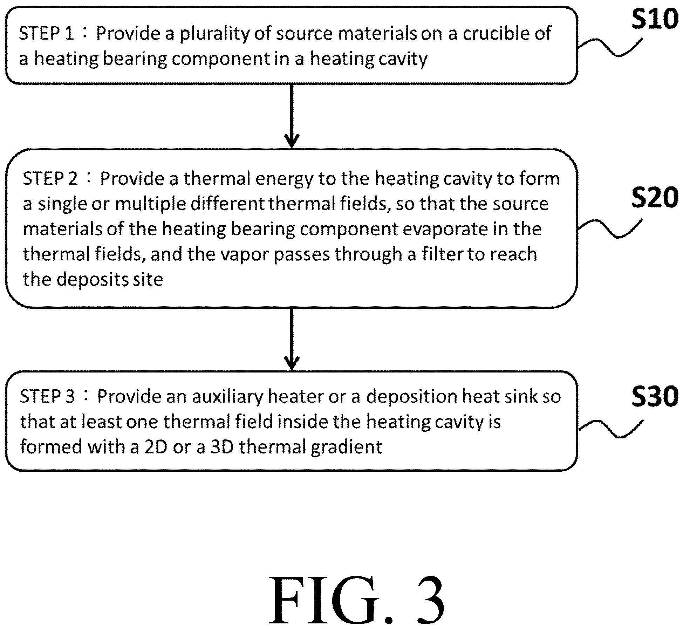

Please refer to Figure 3 in conjunction with Figure 1 for the process flowchart of the crystal growth with multiple deposition sites according to the present invention. The present invention proposes a crystal growth process with multiple deposition sites, which uses a crystal growth apparatus with multiple deposition sites, including the following steps:
Step 1 (S10): Provide a plurality of source materials on a crucible of a heating bearing component in a heating cavity;
Step 2 (S20): Provide a thermal energy to the heating cavity to form a single or multiple different thermal fields, so that the source materials of the heating bearing component evaporate in the thermal fields, and the vapor passes through a filter to reach the deposits site; and
Step 3 (S30): Provide an auxiliary heater or a deposition heat sink so that at least one thermal field inside the heating cavity is formed with a 2D or a 3D thermal gradient.

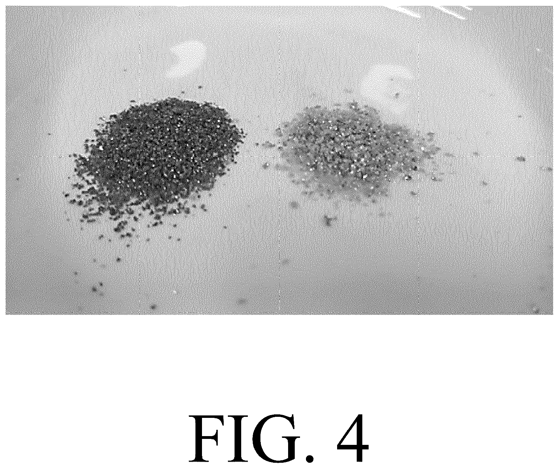

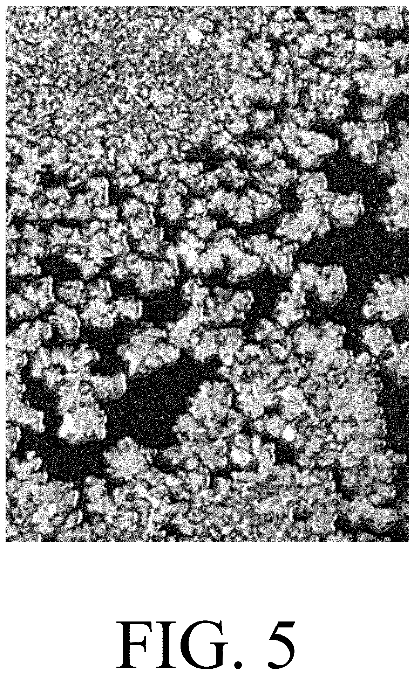

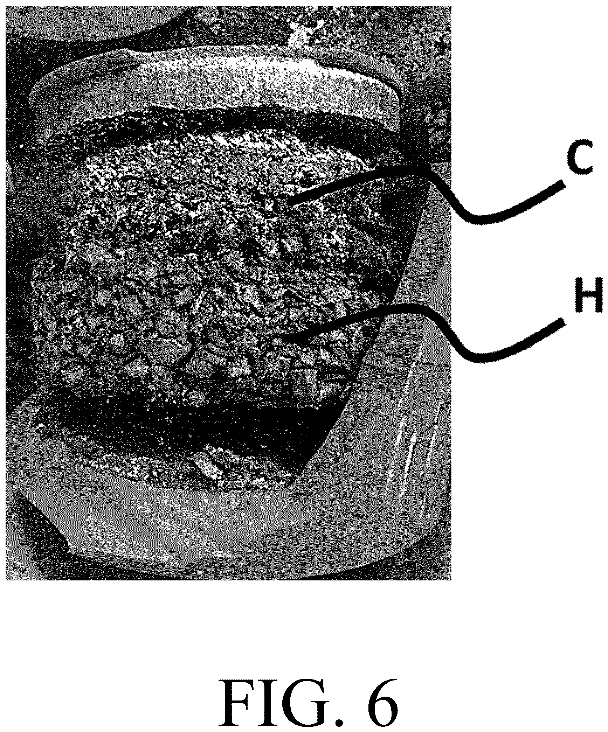

Please refer to FIG. 4, FIG. 5, and FIG. 6 now. FIG. 4 is a schematic photographic of the source materials in the heating bearing component of the present invention. The state of the source material 23 can be a liquid phase, a solid phase, a gas phase, and a mixed phase. FIG. 5 is a schematic photograph of the deposition sites in the heating bearing component of the present invention, with a powdery crystal as a nucleation point. FIG. 6 is a schematic photograph of the compound crystal in the heating bearing component of the present invention. Since there are multiple different thermal fields 28 in the heating cavity 10, the crystal sizes of the compound crystals are different. The upper part is the crystal form C formed in the relatively cold zone (cold zone), and the lower part is the relatively hot zone (hot zone), zone), and the crystal size of the crystal form C formed in the relatively cold spot area will be smaller than the crystal size of the crystal form H formed in the relatively hot spot area.

In summary, the crystal growth apparatus and process with multiple deposition sites of the present invention have the following effects:
(1) Versatile crystal growth apparatuses are easy to manufacture and integrate.
(2) The heating cavity creates a single or multiple different thermal fields.
(3) Multiple deposition sites generate 2D or 3D thermal gradients.
(4) Stable and rapid production of compound crystals with few defects.

It will be apparent to those skilled in the art that various modifications and variations can be made to the present disclosure. It is intended that the specification and examples be considered as exemplary embodiments only, with a scope of the disclosure being indicated by the following claims and their equivalents.

## Claims

1. A crystal growth apparatus with multiple deposition sites, comprising:
a heating cavity (10) with rotatable a pillar (12) inside;
at least one heating bearing component (20) is connected to the pillar (12), the heating bearing component (20) includes a crucible (22), a filter (24), and a plurality of deposition sites (26-1, 26-2, 26-3), the crucible (22) has a plurality of source materials (23);
a heat generator (40), disposed inside the heating cavity (10), for providing the heat energy to the heating cavity (10); and
a plurality of rigid devices (30-1, 30-2, 30-3, 30-4) serves as an auxiliary heater or a deposition heat sink, so that at least one thermal filed inside the heating cavity (10) is formed with a 2D or a 3D thermal gradient.

2. The crystal growth apparatus with multiple deposition sites according to claim 1, wherein the heat generator (40) is a radio frequency heating coil, forming a single or multiple different thermal fields in the heating cavity (10), and the source materials (23) of the heating bearing component (20) evaporate in the thermal fields, and the vapor passes through the filter (24) and reaches the depositions sites (26-1, 26-2, 26-3).

3. The crystal growth apparatus with multiple deposition sites according to claim 1, wherein a plurality of insulators (70-1, 70-2) disposed inside the heating cavity (10) to protect a cylinder or a rectangular water jacket (14) on the surface of the heating cavity (10).

4. The crystal growth apparatus with multiple deposition sites according to claim 1, wherein a plurality of thermal field adjustment component (70-1, 70-2), which are disposed inside the heating cavity (10) and between the heating bearing components, so that each heating bearing component of the heating cavity is in a thermal field with different thermal gradients.

5. The crystal growth apparatus with multiple deposition sites according to claim 1, wherein the material of the crucible (22) is selected from one of an alloy, a metal, a ceramic or a compound material, or a combination thereof.

6. The crystal growth apparatus with multiple deposition sites according to claim 1, wherein a gas is introduced into the heating cavity (10), and the gas system is selected from one of Ar, N₂, CO, CO₂ and doping gases, and the Gas pressure range is from 10⁻⁶mbar to 10 atm.

7. The crystal growth apparatus with multiple deposition sites according to claim 1, wherein the state of the source materials (23) can be liquid phase, solid phase, gas phase and mixed phase, and the deposition sites have a powdery crystal as a nucleation point, and the powdery crystal is selected from one of SiC, GaN, AlN or Ga₂O₃ powdery crystals.

8. The crystal growth apparatus with multiple deposition sites according to claim 1, wherein the viewports at the top, middle and bottom of the heating cavity (10) are equipped with an infrared pyrometer (50) to detect the temperature of the heating cavity (10).

9. The crystal growth apparatus with multiple deposition sites according to claim 1, wherein the filter (24) is used to regulate the gases that are heated and sublimate of the source materials (23), and will have different filtration speeds along with the thermal gradients of different thermal fields.

10. The crystal growth process with multiple deposition sites according to claim 1, uses the crystal growth apparatus with multiple deposition sites, including the following steps:
Providing a plurality of source materials (23) on a crucible (22) of a heating bearing component (20) in a heating cavity (10);
Providing a heat energy to the heating cavity (10) to form a single or multiple different thermal fields, so that the source materials (23) of the heating bearing component (20) evaporate in the thermal fields, and the vapor reaches the deposition sites through a filter (24); and
An auxiliary heater or a deposition heat sink is provided so that the thermal field inside the heating cavity (10) is formed with a 2D or a 3D thermal gradient.
